(19) Europäisches Patentamt
European Patent Office
Office européen des brevets

(11) **EP 2 717 063 B1**

(12) **EUROPÄISCHE PATENTSCHRIFT**

(45) Veröffentlichungstag und Bekanntmachung des Hinweises auf die Patenterteilung:
**22.08.2018 Patentblatt 2018/34**

(51) Int Cl.:
*G01R 27/02* (2006.01)        *G01R 27/18* (2006.01)
*H02H 3/17* (2006.01)        *G01R 31/12* (2006.01)
*H02H 5/10* (2006.01)

(21) Anmeldenummer: **13184524.0**

(22) Anmeldetag: **16.09.2013**

(54) **Verfahren zur Überwachung und Messung eines Isolationswiderstands mit einem störresistenten Messignal**

Method for monitoring and measuring an insulating resistance with an interference-resistant measurement signal

Procédé de surveillance et de mesure d'une résistance d'isolation à l'aide d'un signal de mesure résistant au brouillage

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.10.2012 DE 102012218107**

(43) Veröffentlichungstag der Anmeldung:
**09.04.2014 Patentblatt 2014/15**

(73) Patentinhaber: **Bender GmbH & Co. KG**
**35305 Grünberg (DE)**

(72) Erfinder:
• **Dr. Bröckmann, Eckhard**
  **35396 Gießen (DE)**
• **Dipl.-Ing. Macht, Burkhard**
  **35410 Hungen (DE)**
• **Dipl.-Ing. Hackl, Dieter**
  **35463 Fernwald (DE)**

(74) Vertreter: **advotec.**
**Patent- und Rechtsanwälte**
**Georg-Schlosser-Straße 6**
**35390 Gießen (DE)**

(56) Entgegenhaltungen:
**WO-A1-2007/054700      DE-B- 1 023 818**

**US-A1- 2011 085 272**

• **M. SCHROEDER: "Synthesis of low-peak-factor signals and binary sequences with low autocorrelation (Corresp.)", IEEE TRANSACTIONS ON INFORMATION THEORY, Bd. 16, Nr. 1, 1. Januar 1970 (1970-01-01) , Seiten 85-89, XP055099664, ISSN: 0018-9448, DOI: 10.1109/TIT.1970.1054411**
• **E Van Der Ouderaa ET AL: "Peak factor minimization of input and output signals of linear systems", IEEE Transactions on Instrumentation and Measurement, 1. Januar 1988 (1988-01-01), Seiten 207-212, XP055099665, DOI: 10.1109/19.6053 Gefunden im Internet: URL:http://ieeexplore.ieee.org/xpls/abs_all.jsp?arnumber=6053 [gefunden am 2014-01-30]**
• **SCHOUKENS ET AL: "Survey of excitation signals for FFT based signal analyzers", IEEE TRANSACTIONS ON INSTRUMENTATION AND MEASUREMENT, Bd. 37, Nr. 3, 1. Januar 1988 (1988-01-01) , Seiten 342-352, XP055099667, ISSN: 0018-9456, DOI: 10.1109/19.7453**
• **MART MIN ET AL: "Binary signals in impedance spectroscopy", ENGINEERING IN MEDICINE AND BIOLOGY SOCIETY (EMBC), 2012 ANNUAL INTERNATIONAL CONFERENCE OF THE IEEE, IEEE, 28. August 2012 (2012-08-28), Seiten 134-137, XP032462878, DOI: 10.1109/EMBC.2012.6345889 ISBN: 978-1-4244-4119-8**

**Beschreibung**

Die Erfindung betrifft ein Verfahren zur Überwachung und Messung eines Isolationswiderstandes in ungeerdeten und geerdeten Stromversorgungssystemen mit den Verfahrensschritten: Erzeugung eines periodischen Messsignals, Einkopplung des Messsignals zwischen aktiven Leitern des zu überwachenden Stromversorgungssystems und Erde sowie der Erfassung und Auswertung von Messsignal-Messwerten.

Weiterhin betrifft die Erfindung einen Signalgenerator zur Überwachung eines Isolationswiderstandes in ungeerdeten und geerdeten Stromversorgungssystemen, mit einer Signalgeneratorschaltung zur Erzeugung eines periodischen Messsignals und mit einer Ankopplungsschaltung zur Einkopplung des Messsignals zwischen aktiven Leitern des zu überwachenden Stromversorgungssystems und Erde.

Im Hinblick auf den Personen, Anlagen- und Brandschutz bei elektrischen Stromversorgungssystemen und Betriebsmitteln ist die Überwachung des Isolationswiderstandes, also des Widerstands in dem zu überwachenden Stromversorgungssystem einschließlich der Widerstände aller daran angeschlossenen Betriebsmittel gegen Erde, eine unabdingbare Voraussetzung für einen störungsfreien Betrieb der elektrischen Anlage. Ohne ausreichend großen Isolationswiderstand ist der Schutz gegen direktes und indirektes Berühren nicht mehr gewährleistet, es können Fehlfunktionen der elektrischen Einrichtungen zu Personengefährdungen, Produktionsausfall oder Anlagenstillstand führen oder Kurz- und Erdschlussströme können Brände und Explosionen verursachen. Bei neu errichteten Anlagen und Betriebsmitteln ist der Isolationswiderstand in der Regel ausreichend groß, kann aber im Laufe des Betriebs der Anlage durch elektrische oder mechanische Einwirkungen sowie durch Umwelteinflüsse und Alterungseffekte herabgesetzt werden.

Eine Messung des Isolationswiderstands kann sowohl in geerdeten Netzen (TN-Systemen) als auch in ungeerdeten Netzen (IT-Systemen) durchgeführt werden, wobei die ständige Überwachung des absoluten Isolationswertes während des Betriebs eine herausragende Rolle spielt. Zur Messung werden - unabhängig von der Netzform - ein Signalgenerator und eine Messeinrichtung zwischen die aktiven Leiter eines Stromversorgungssystems und Erde geschaltet, wobei der Signalgenerator eine Messsignalspannung in das Netz eingeprägt, so dass im Falle eines Isolationsfehlers ein geschlossener Stromkreis entsteht, in dem sich ein dem Isolationsfehler proportionaler Messstrom einstellt. Dieser Messstrom wird von der Messeinrichtung erfasst und erlaubt somit eine Aussage über die Größe des Isolationswiderstands.

In heutigen modernen Netzen ist eine Vielzahl von Betriebsmitteln mit elektronischen Bauelementen versehen. Um im Hinblick auf eine zuverlässige Isolationsüberwachung Messverfälschungen entgegenzuwirken, hervorgerufen beispielsweise durch von Umrichtern erzeugte Gleichstromkomponenten, sind die Messverfahren stets weiter entwickelt worden. Es ist daher bekannt, in reinen Wechselstromnetzen ohne verfälschende Gleichspannungsanteile das Verfahren der Überlagerung einer Messgleichspannung einzusetzen, wohingegen in störungsbehafteten Umgebungen eine gesteuerte, speziell getaktete Messspannung mit Rechteck-förmigen Generator-Impulsformen zur Anwendung gelangt. Derartige, in gegenwärtig auf dem Markt befindlichen Überwachungsgeräten verwendete Rechteckimpuls-Folgen erweisen sich zwar als relativ unempfindlich gegenüber breitbandigen Störsignalen, zeigen aber eine ungenügende Robustheit beim Auftreten schmalbandiger Störer.

Aus der Patentschrift DE 38 82 833 T2 ist weiter die Einspeisung eines Wechselspannungs-Referenzsignals bekannt, auf dessen Grundlage über eine geeignete Auswerteschaltung Real- und Imaginärteil einer komplexen Isolationsimpedanz berechnet werden können. Da das sinusförmige Referenzsignal nur eine Frequenzkomponente aufweist, ist es relativ störempfindlich gegenüber Störsignalen, die in dem Bereich der Frequenz des Referenzsignals auftreten.

Um niederfrequenten Störungen besser begegnen zu können, wird in der EP 0 593 007 B1 die Berechnung der komplexwertigen Netzableitimpedanz auf der Basis von zwei amplitudenkonstanten, periodischen Messsignal-Wechselspannungen vorgeschlagen. Allerdings sollten die Frequenzen der beiden Wechselspannungen in einem weitgehend störsignalfreien Bereich liegen und relativ niedrig sein, damit die Netzableitgrößen unter Vernachlässigung der Netzinduktivitäten mit einem vereinfachten Funktionszusammenhang berechnet werden können.

Das Dokument US2011/0085272 A1 offenbart ein Verfahren zur Überwachung und Messung eines Isolationswiderstandes in ungeerdeten und geerdeten Stromversorgungssystemen, das alle Merkmale des Oberbegriffs der unabhängigen Ansprüche 1, 9 und 16 aufweist.

Die aus dem Stand der Technik bekannten Verfahren zur Bestimmung des Isolationswiderstandes weisen gegenüber schmalbandigen Störsignalen, insbesondere gegenüber Störsignalen mit nur einer diskreten Frequenz, eine unzureichende Störresistenz auf. Zudem sind an die verwendeten Messsignale Auswertemethoden gebunden, die auf die jeweilige Messsignalform abgestimmt sind und unterschiedliche Leistungsfähigkeiten hinsichtlich der Unterdrückung von Störsignalen zeigen. Insgesamt betrachtet ist das Problem der Störerunterdrückung bisher unbefriedigend gelöst.

Der vorliegenden Erfindung liegt somit die Aufgabe zu Grunde, ein Verfahren und eine Vorrichtung zur Überwachung und Messung eines Isolationswiderstandes weiter zu entwickeln, die gegenüber Störsignalen, insbesondere gegenüber schmalbandigen Störsignalen, eine erhöhte Störunempfindlichkeit aufweisen.

Simulationen von störbehafteten Stromversorgungssystemen haben ergeben, dass bestimmte Arten von Störsignalen, wie beispielsweise Oszillationen, hervorgerufen durch weitere an das Netz angeschlossene elektrische Anlagen und Betriebsmittel, gut zu unterdrücken sind, wenn das Frequenzspektrum des erzeugten periodischen Messsignals aus wenigen diskreten Komponenten besteht, sich also aus einer Fourier-Reihe mit einer endlichen Anzahl von Fourier-Komponenten zusammensetzt. Dieses Merkmal wird im Folgenden mit dem Begriff "Multifrequenz" bezeichnet. Da hier nur periodische Messsignale beschrieben werden und ein periodisches Signal stets ein Linienspektrum (frequenzdiskretes Spektrum) besitzt, sollen unter dem Begriff "Spektrum" die Fourier-Koeffizienten der Harmonischen verstanden werden, wobei die erste Harmonische oder Harmonische erster Ordnung der harmonischen Schwingung mit der Grundfrequenz (Generatorfrequenz) $f_{gen}$ entspricht und die n-te Harmonische oder Harmonische n-ter Ordnung die Frequenz $nf_{gen}$ aufweist.

Die Verwendung eines derartigen Multifrequenz-Signals, das durch die Überlagerung von einer endlichen Anzahl harmonischer Schwingungen - in der Regel von einem Sinussignal einer Grundfrequenz und deren Harmonischen - gebildet wird, besitzt den Vorteil, dass störende Oszillationen wirksam unterdrückt werden, da diese nur eine einzige Komponente des Fourier-Spektrums beeinträchtigen können. Die übrigen ungestörten Fourier-Koeffizienten erlauben noch eine Mehrheitsentscheidung über den korrekten Wert der Isolationsimpedanz, sofern das Messsignal erfindungsgemäß aus mindestens drei überlagerten Schwingungen (Harmonischen) gebildet wird. Damit lässt sich das Messsignal $U_{gen}$ (Generatorspannung) darstellen als

$$U_{gen}(t) = \sum_{n=1}^{N} \cos\left(2\pi n f_{gen} t\right) \qquad (1)$$

mit $f_{gen}$: Generator-Grundfrequenz, n: Ordnung der Harmonischen.

Die Periodendauer der Generator-Grundfrequenz ergibt sich damit zu $T_{gen} = 1/f_{gen}$. Die zu Gleichung (1) gehörenden Fourier-Koeffizienten sind reellwertig mit dem Betrag 1.

In vorteilhafter Ausgestaltung des Verfahrens wird das Verhältnis von Scheitelwert zu Effektivwert des Messsignals minimiert.

Das in Gleichung (1) beschriebene Messsignal ist einfach zu erzeugen und zeigt im Vergleich zu aus dem Stand der Technik bekannten Rechteckimpuls-Folgen gegenüber schmalbandigen Störsignalen eine verbesserte Störunempfindlichkeit. Diese lässt sich jedoch noch weiter steigern, wenn die Effektivwerte bzw. die Leistungen überlagerter Sinussignale unter gegebenen Aussteuerungsgrenzen des Generators dahingehend optimiert werden, dass ein maximal möglicher Signal-Rausch-Abstand (SNR) angestrebt wird. Bei gegebener Störsignalleistung ist diese Vorgehensweise gleichbedeutend mit einer Maximierung der Messsignalleistung (Nutzsignalleistung) und entspricht damit einer Minimierung des Verhältnisses von Scheitelwert zu Effektivwert (Scheitelfaktor, Crest-Faktor) des Messsignals.

Bevorzugt erfolgt die Minimierung des Verhältnisses von Scheitelwert zu Effektivwert des Messsignals durch eine Phasenoptimierung.

Die Frequenzen der ausgewählten Harmonischen bleiben in vorteilhafter Weise bei einer Phasenoptimierung unverändert, es werden lediglich deren Phasen gegeneinander so verschoben, dass der Crest-Faktor ein Minimum erreicht oder zumindest möglichst klein wird. Infolge der zeitlichen (Phasen-)Verschiebung ergeben sich komplexwertige Fourier-Koeffizienten, das Betragsspektrum ist demgegenüber invariant.

Mit Vorteil erfolgt die Phasenoptimierung nach der Schröder-Phasengleichung

$$\varphi_n = \frac{\pi n(n-1)}{N} \qquad , \qquad (2)$$

wobei $\varphi_n$ die Phase der Harmonischen n-ter Ordnung und N die Anzahl der Harmonischen ist.

Diese aus der Akustik bekannte Phasenoptimierung nach M. R. Schröder (1970) lässt sich rechentechnisch in einfacher Weise auf die endliche Anzahl der harmonischen Messsignalkomponenten übertragen und somit ein möglichst kleiner Crest-Faktor erzielen.

Eingesetzt in Gleichung (1) ergibt die Schröder-Phasengleichung (2) das Messsignal

$$U_{gen}(t) = \sum_{n=1}^{N} \cos\left(\frac{\pi n(n-1)}{N} + 2\pi n f_{gen} t\right) \qquad (3)$$

mit komplexwertigen Fourier-Koeffizienten, deren Beträge gleich 1 sind.

Eine weitere, alternative Ausgestaltung besteht darin, dass die Phasenoptimierung durch Berechnung von Messsignalformen mit inkrementellen Phasenvariationen der Harmonischen erfolgt.

Mittels eines Rechenprogramms werden die Phasen der einzelnen Harmonischen inkrementell variiert, bis ein akzeptables Minimum des Crest-Faktors gefunden ist. Das mit dieser Phasenoptimierung durch Phasenvariation erzeugte Messsignal ergibt sich dann zu

$$U_{gen}(t) = \sum_{n=1}^{N} \cos\left(\varphi_{n,v} + 2\pi n f_{gen} t\right) \quad, \tag{4}$$

wobei $\varphi_{n,v}$ die Phasen der einzelnen Harmonischen nach der Phasenvariation sind.

Beide vorgenannten Optimierungsmethoden verfolgen somit das Ziel, durch eine Minimierung des Crest-Faktors ein möglichst großes Signal-Rauschleistungsverhältnis zu erreichen. Bei einer geringen Anzahl von Harmonischen beansprucht das Verfahren der Phasenvariation nicht viel Rechenzeit und liefert den kleinsten Crest-Faktor. Bei sehr vielen Harmonischen hingegen scheint die Phasenoptimierung nach Schröder das effizientere Verfahren zu sein.

In vorteilhafter Ausführung des Verfahrens steigen die Amplituden der Harmonischen monoton mit der Frequenz an.

Die Phasenoptimierung nach der Schröder-Phasengleichung (2) geht von gleich großen Amplitudenwerten für jede Harmonische aus. Da aber infolge des kapazitiven Anteils (Ableitkapazität) der Isolationsimpedanz die Harmonischen höherer Ordnung stärker gedämpft werden als die Grundfrequenz, ist bei der Erzeugung des Messsignals eine mit der Frequenz ansteigende Amplitudenerhöhung der einzelnen Messsignalkomponenten sinnvoll, um auch bei der höchsten gewünschten Harmonischen ein noch ausreichendes Signal-Rauschleistungs-Verhältnis zu gewährleisten. In Gleichung (4) wird daher noch zusätzlich der Amplitudenfaktor $a_n$ eingeführt:

$$U_{gen}(t) = \sum_{n=1}^{N} a_n \cos\left(\varphi_{n,v} + 2\pi n f_{gen} t\right) \quad, \tag{5}$$

wobei die Beträge der komplexwertigen Fourier-Koeffizienten durch die Koeffizienten $a_n$ gegeben sind. Der Tiefpasswirkung der komplexwertigen Isolationsimpedanz kann somit wirksam begegnet werden.

Vorzugsweise wird die Amplitudenerhöhung derart implementiert, dass die Amplituden der Harmonischen linear mit der Frequenz ansteigen. Berechnungen haben gezeigt, dass eine einfache lineare Beziehung der Amplitudenfaktoren $a_n$ über die Frequenz in der Praxis ausreichend ist, so dass die Zunahme der Amplitudenfaktoren $a_n$ als Funktion der Ordnung n der Harmonischen ausgedrückt werden kann als:

$$a_n = a_1 + b(n - 1) \tag{6}$$

Mit einer Steigung b im Bereich 0.5 bis 1 werden dabei gute Ergebnisse erzielt. Die Phasenoptimierung kann auch in diesem Fall nach dem Verfahren der Phasenvariation durchgeführt werden, bis ein Minimum des Crest-Faktors gefunden wird.

Weiterhin kann zur Maximierung der Leistungen ausgewählter Harmonischer eine kontrollierte Übersteuerung des Messsignals dadurch erfolgen, dass eine Begrenzung und/oder ein Verstärkungsfaktor und/oder eine DC-Verschiebung einstellbar sind.

Falls EMV-Erscheinungen keine Rolle spielen und das Auswerteverfahren auch ungewollte Harmonische, d.h. nicht genutzte Harmonische - im Gegensatz zu den ausgewählten, zur Auswertung nutzbaren Harmonischen - tolerieren kann, ist eine weitere Steigerung der Leistung der Harmonischen durch eine kontrollierte Übersteuerung des Multifrequenz-Signals möglich. Als Parameter der Übersteuerung können dabei im Rahmen einer durch eine Begrenzung vorgegebenen Signalamplitude (Aussteuerbereich) der Verstärkungsfaktor und/oder eine DC-Verschiebung eingestellt werden. Durch einen größer werdenden Verstärkungsfaktor nimmt die Flankensteilheit - und damit der Pegel höherer Harmonischer - zu. Daneben kann eine optionale DC-Verschiebung noch mehr Gewinn an Leistung der einzelnen Harmonischen erbringen, wodurch innerhalb des Aussteuerbereichs mehr Platz für Amplituden der Harmonischen geschaffen werden kann. Man hat mit der Veränderung der beiden Parameter Verstärkungsfaktor und DC-Verschiebung die Möglichkeit, bei Beobachtung des sich verändernden resultierenden Spektrums eine Maximierung der Leistungen der Harmonischen vorzunehmen. Durch Übergang der kontrollierten Übersteuerung zu einer extremen Übersteuerung kann eine Rechteckimpuls-Folge derart erzeugt werden, dass die Leistungen ausgewählter Harmonischer in einem vorgegeben Aussteuerbereich maximal werden.

Wird der Verstärkungsfaktor derart erhöht, dass das Signal bei nahezu unendlicher Flankensteilheit in ein Rechtecksignal übergeht, so können die Leistungen der ausgewählten Harmonischen bei vorgegebenem Aussteuerbereich maximal werden. Es wird die Aufgabe bezogen auf ein Verfahren in Verbindung mit dem Oberbegriff des Anspruchs 1 dadurch gelöst, dass das erzeugte Messsignal als Multifrequenz-Signal durch eine Rechteckimpuls-Folge konstruiert wird, wobei ein die Folge bildender Rechteckimpuls in m gleichlange Teilabschnitte unterteilt wird, die m Teilabschnitte in geordneter Vorgehensweise jeweils binärwertig entweder unipolar auf 0/1 oder bipolar auf -1/+1 gesetzt werden, für jede der $2^m$ möglichen Rechteckimpuls-Folgen Fourier-Koeffizienten für ausgewählte Harmonische berechnet werden und diejenige Rechteckimpuls-Folge ausgewählt wird, die vorgegebene Anforderungen an ihre spektrale Zusammensetzung erfüllt. Alternativ zu dem vorgenannten Verfahren kann das Multifrequenz-Signal auch durch eine gezielte abschnittsweise Konstruktion der Signalform im Zeitbereich erfolgen, um bestimmte Anforderungen an die Zusammensetzung im Spektralbereich zu erfüllen. Ausgangspunkt ist eine Binärfolgen-Optimierung, bei der der die Rechteckimpuls-Folge bildende Rechteckimpuls mit der Dauer $T_{gen}$ zunächst in m Teilabschnitte unterteilt wird, diese Teilabschnitte dann mit den möglichen binären Kombinationen belegt wird und die jeweilige spektrale Zusammensetzung der resultierenden $2^m$ Signalverläufe ausgewertet wird. Ausgewählt wird diejenige Folge, deren Fourier-Koeffizienten an den interessierenden Frequenzstellen im Rahmen zugestandener Toleranzen die vorgegebenen Forderungen erfüllen.

Als Kriterien, die dabei an die Amplitudenverteilung der Fourier-Koeffizienten gestellt werden, kommt entsprechend dem übergeordneten Entwicklungsziel der Erzeugung eines störresistenten Messsignals vorzugsweise in Betracht, dass beispielsweise die Leistungen ausgewählter Harmonischer in einem vorgegeben Aussteuerbereich maximal werden, dass niedrige Harmonische einer Grundfrequenz unterdrückt werden, dass die Amplituden der Harmonischen monoton mit der Frequenz ansteigen und/oder dass die Amplituden der Harmonischen linear mit der Frequenz ansteigen.

In weiterer Ausgestaltung können die Flanken der Rechteckimpuls-Folge durch Einfügen interpolierender Stützstellen nachbearbeitet werden, so dass sich eine von dem Rechteckimpuls abweichende Signalform ergibt.

Rechteckimpuls-Folgen können bei fehlender oder sehr geringer Ableitkapazität die elektronischen Bauelemente der Messanordnung hinsichtlich der Übertragungsbandbreite überfordern. Beispielsweise entstehen im Falle eines Delta-Sigma-Analog-Digital-Umsetzers Abtastfehler bei steilen Flanken des Eingangssignals oder Operationsverstärker erzeugen Fehler auf Grund ihrer begrenzten Flankensteilheit (Anstiegsrate - slew rate). Einen Ausweg bietet sich daher durch die Modifizierung der erzeugten Rechteckimpuls-Folgen in der Weise an, dass interpolierende Stützstellen in den Signalverlauf eingefügt werden. Dadurch ergibt sich eine von dem Rechteckimpuls abweichende Signalform mit günstigerem, bandbegrenzten Spektralverlauf.

Vorzugsweise werden durch linear interpolierende Stützstellen Trapezimpuls-Folgen erzeugt.

Diese Folgen verfügen über eine endliche Flankensteilheit und entlasten dadurch die elektronischen Bauelemente. Die Generatorperiode $T_{gen}$ wird in noch feinere Zeitabschnitte zerteilt und die Abtastwerte der Generatorspannung $U_{gen}$ werden - bei bipolarer Darstellung - nicht nur auf -1 oder auf +1 gesetzt, sondern zwischen den -1/+1-Wechseln, also im Flankenbereich, noch linear interpolierende Stützstellen eingefügt. Ist nur eine zusätzlich Stützstelle möglich, wird man eine Null einfügen, sind beispielsweise drei zusätzliche Stützstellen möglich, dann wird man -½, 0, ½ einfügen bzw. ½, 0, -½. Infolge der weniger steilen Pegelübergänge schwächen sich die Anteile höherer Harmonischer ab. Sollten höhere, nicht zur Auswertung herangezogene Harmonische dennoch stören, so kann die Anzahl möglicher interpolierender Stützstellen zwischen den +1/-1-Wechseln weiter erhöht werden

In weiterer Ausgestaltung können durch die interpolierenden Stützstellen Impulse mit Kosinusflanken oder mit weitgehend linear verlaufenden Flanken und abgerundeten Übergängen zu konstanten Abschnitten erzeugt werden.

Das Einfügen linear interpolierender Stützstellen führt zu einer Trapezform des Messsignals, weist daher immer noch scharfkantige, hohen Frequenzanteilen entsprechende Übergänge im Zeitverlauf auf. Eine weitere Abschwächung höherer Harmonischer in Richtung auf ein insgesamt bandbegrenztes Messsignal lässt sich erreichen, in dem die linearen Flanken durch kosinusförmige Flanken ersetzt werden. Auch eine Zwischenform mit weitgehend linear verlaufenden Flanken und abgerundeten Übergängen zu konstanten Abschnitten führt infolge des weniger scharfkantigen Signalverlaufs zu einer Abschwächung der höheren Harmonischen. Diese Flankenform kann bei einigen Auswerteverfahren die Auflösung sehr kleiner Zeitkonstanten der Isolationsimpedanz verbessern und wird angewandt, wenn man die maximale Anstiegsrate begrenzen möchte. Es hat sich dabei herausgestellt, dass die Rundungsbereiche recht klein sein sollten, weil sonst wieder Leistung der höchsten Nutz-Harmonischen verloren geht.

Weiterhin wird die Aufgabe bezogen auf ein Verfahren in Verbindung mit dem Oberbegriff des Anspruchs 9 dadurch gelöst, dass das erzeugte Messsignal als Multifrequenz-Signal innerhalb einer Messsignalperiode durch zeitlich aufeinanderfolgende und stetig ineinander übergehende Signalabschnitte gebildet wird, die mit Funktionen unterschiedlicher, ausgewählter Ordnung eines orthogonalen Funktionensystems belegt werden.

Wird prinzipiell von einer Auswertemethode ausgegangen, bei der sich die Auswertung über mehr als eine Generatorperiode erstreckt, können die einzelnen Harmonischen zeitlich aufeinanderfolgend im Zeitmultiplex-Verfahren erzeugt werden. Dabei setzt sich eine Messsignalperiode (Wiederholperiode des Messsignals - entspricht der Auswerteperiode) aus mehreren Signalabschnitten zusammen, deren Anzahl der Anzahl ausgewählter Harmonischer entspricht und die stetig ineinander übergehend mit Funktionen der ausgewählten Ordnungen eines orthogonalen Funktionensystems belegt werden. Die unterschiedlichen n-ten Ordnungen repräsentieren die verschiedenen n-ten Harmonischen und erlauben so eine gezielte spektrale Zusammensetzung des Multifrequenz-Signals. Daneben können unter Ausnutzung der zeitlichen Orthogonalität auch Funktion gleicher Ordnung aufgenommen werden, z.B. Sinus- und Kosinusfunktionen gleicher Frequenz, um durch Realteil- und Imaginärteil-Auswertungen die komplexwertige Isolationsimpedanz bestimmen zu können.

Bevorzugt sind die Funktionen sinusförmige Funktionen und deren Harmonische. Als einfache Implementierung von Basisfunktionen eines orthogonalen Funktionensystems bieten sich sinusförmige Funktionen an. Bei diesen Funktionen kann zur Steigerung des Effektivwertes höherer Harmonischer eine Übersteuerung und/oder eine Begrenzung der Signalabschnitte erfolgen.

Alternativ können die Funktionen auch Rechteckfunktionen, Walsh-Funktionen, Trapez-förmige Funktionen oder Funktionen mit Kosinusflanken sein.

Insbesondere eignen sich die Funktionen des orthogonalen Walsh-Funktionensystems dazu, mit einem entsprechenden Auswerteverfahren den Real- und Imaginärteil der Isolationsimpedanz zu bestimmen, wohingegen sich Funktionen mit Kosinusflanken durch gute Spektraleigenschaften im Sinne einer Bandbreitenbegrenzung auszeichnen.

Die Trapez-förmigen Funktionen können weitgehend linear verlaufende Flanken und abgerundete Übergänge zu konstanten Abschnitten aufweisen und besitzen damit die bereits beschriebenen Vorteile einer Abschwächung der unerwünschten höheren Harmonischen.

Erstreckt sich die Auswerteperiode über ein Vielfaches der Generatorperiode, so weisen die Signalabschnitte vorzugsweise gleiche Länge auf. Werden beispielsweise die erste, zweite und dritte Harmonische einer Grundfrequenz zeitlich aufeinanderfolgend erzeugt, so ist es sinnvoll, jeden Signalabschnitt gleich lang mit der Länge einer Generatorperiode auszugestalten, so dass beispielsweise die Wiederholperiode des Multifrequenz-Messsignals das Dreifache der Generatorperiode, bzw. die Wiederholfrequenz des Messsignals ein Drittel der Grundfrequenz beträgt.

Beschränkt sich die Auswerteperiode nicht auf ganzzahlige Vielfache der Generatorperiode, so kann eine Wichtung der Funktionen durch unterschiedlich lange Signalabschnitte erfolgen. Die einzelnen Signalabschnitte, während der die Funktionen unterschiedlicher Ordnung dargeboten werden, entsprechen dabei nicht mehr genau einer Generatorperiode und besitzen eine unterschiedliche Länge. Durch die Wahl der Längenverhältnisse kann eine relative Wichtung zugunsten erwünschter, ausgewählter Harmonischer erzielt werden.

Bezogen auf eine Vorrichtung wird die Aufgabe gelöst durch einen Signalgenerator zur Überwachung eines Isolationswiderstandes in ungeerdeten und geerdeten Stromversorgungssystemen, mit einer Signalgeneratorschaltung zur Erzeugung eines periodischen Messsignals und mit einer Ankopplungsschaltung zur Einkopplung des Messsignals zwischen aktiven Leitern des zu überwachenden Stromversorgungssystems und Erde, wobei die Signalgeneratorschaltung Mittel zur Erzeugung und Speicherung des durch mindestens eines der erfindungsgemäßen Verfahren nach den Ansprüchen 1 bis 8 oder 9 bis 15 erzeugten Multifrequenz-Messsignale aufweist.

Weitere vorteilhafte Ausgestaltungsmerkmale ergeben sich aus der nachfolgenden Beschreibung und den Zeichnungen, die bevorzugte Ausführungsformen der Erfindung an Hand von Beispielen erläutern. Es zeigen:

**Fig. 1:**     schematisch ein Stromversorgungssystem mit Signalgenerator und Messeinrichtung,
**Fig. 2:**     ein Multifrequenz-Signal,
**Fig. 3a, 3b:**     ein Multifrequenz-Signal nach Phasenoptimierung mit Spektrum,
**Fig. 4a, 4b:**     ein übersteuertes Multifrequenz-Signal mit Spektrum,
**Fig. 5a, 5b:**     ein rechteckförmiges Multifrequenz-Signal nach BinärOptimierung mit Spektrum,
**Fig. 6a, 6b:**     ein trapezförmiges Multifrequenz-Signal mit Spektrum,
**Fig. 7:**     Flankenformen modifizierter Rechteck-Impulse ($U_{gen}$) mit Messsignal ($U_a$),
**Fig. 8:**     ein nach dem Zeitmultiplex-Verfahren zusammengesetztes Multifrequenz-Signal,
**Fig. 9:**     ein Spektrum eines nach dem Zeitmultiplex-Verfahren zusammengesetzten Multifrequenz-Signals,
**Fig. 10:**     ein nach dem Zeitmultiplex-Verfahren zusammengesetztes Multifrequenz-Signal mit Signalabschnitten unterschiedlicher Länge und
**Fig. 11:**     das Spektrum des Signals nach Fig. 10.

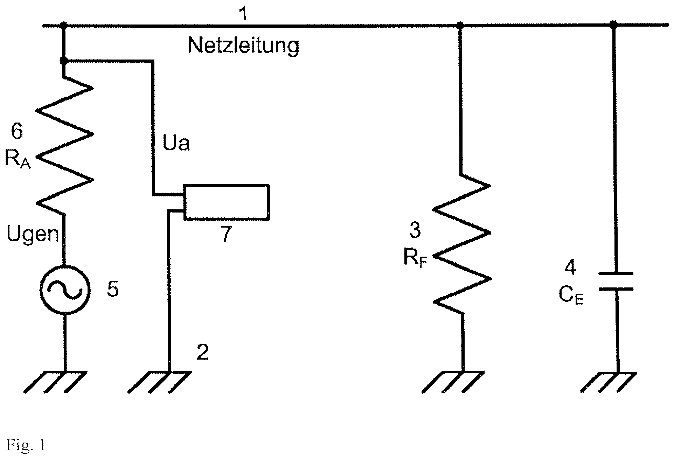

**Fig. 1** zeigt in einer schematischen Darstellung eine Netzleitung 1 eines Stromversorgungssystems, die mit dem Erdpotential 2 über einen (fehlerhaften) Isolationswiderstand $R_F$ 3 und eine Ableitkapazität $C_E$ 4 verbunden ist. Eine Signalgeneratorschaltung 5 einer Überwachungseinrichtung, beispielsweise eines Isolationsüberwachungsgerätes, erzeugt ein Messsignal $U_{gen}$ (Generatorspannung), das über einen Ankoppelwiderstand $R_A$ 6 auf die Netzleitung 1 gegeben wird. Prinzipiell ist auch die Einkopplung eines Stromsignals als Messsignal statt einer Messspannung möglich, wobei dann der Ankoppelwiderstand $R_A$ entfallen kann. Messsignal-Messwerte auf der Netzleitung werden von einer Messschaltung 7 erfasst und in einer nachfolgenden Auswerteinrichtunge zur Berechnung des Isolationswiderstands $R_F$ 3 und der Ableitkapazität $C_E$ 4 herangezogen.

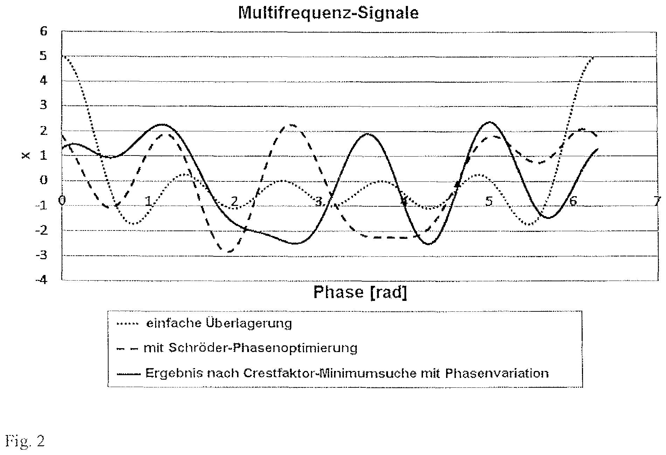

In **Fig. 2** ist ein Multifrequenz-Signal dargestellt. Ausgehend von einer einfachen Überlagerung nach Gl. (1) (punktierte Linie) zeigt die Fig. 2 eine Überlagerung nach der Schröder-Phasenoptimierung gemäß Gl. (3) (gestrichelte Linie) und das Ergebnis einer Crest-Faktor-Minimierung nach einer Phasenoptimierung durch Phasenvariation gemäß Gl. (4) (durchgezogenen Linie). Beide Phasenoptimierten Verfahren weisen erkennbar kleinere Extremwerte im Amplitudenverlauf auf, wobei letztere Kurve zu den kleineren Extremwerten führt.

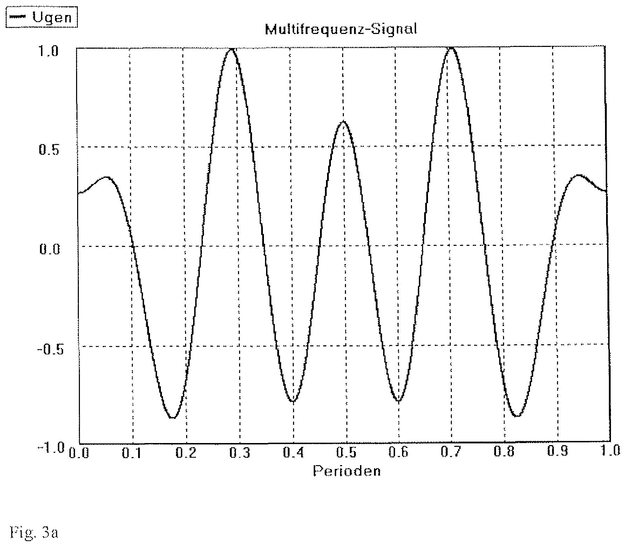

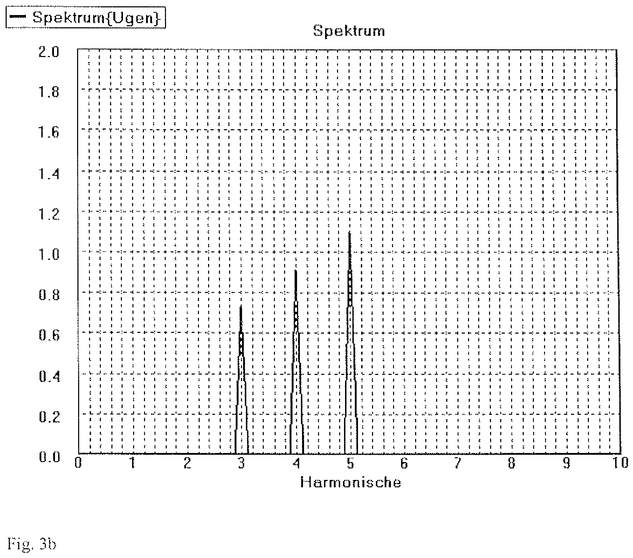

Die **Fig. 3a** und **3b** zeigen ein Multifrequenz-Signal nach Phasenoptimierung mit dazugehörigem Spektrum. Das Multifrequenz-Signal setzt sich aus drei Frequenzen zusammen, nämlich aus der 3., 4. und 5. Harmonischen einer Grundfrequenz, und ist derart ausgesteuert, dass sich eine frequenzlineare Zunahme der Amplitudenfaktoren ergibt.

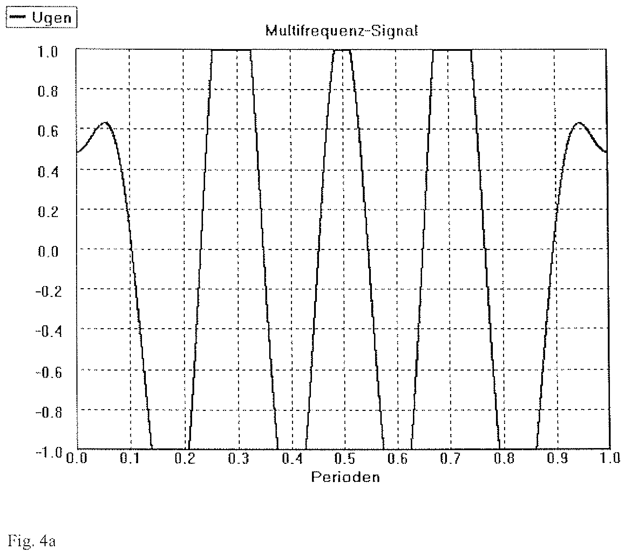

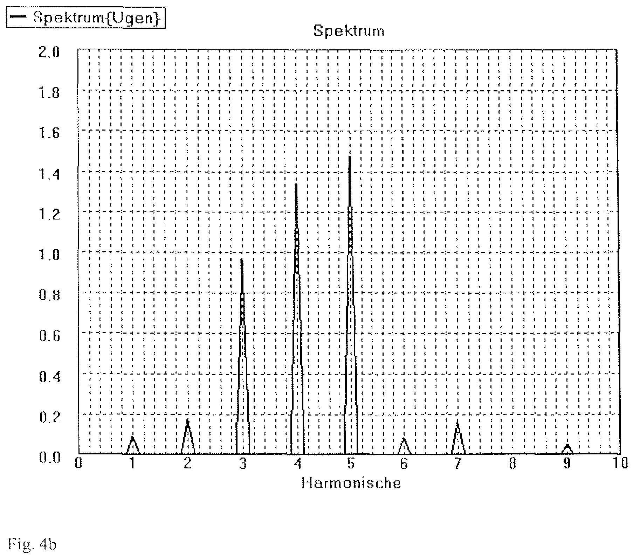

In den **Fig. 4a** und **4b** ist das Multifrequenz-Signal aus den Fig. 3a und 3b mit Übersteuerung dargestellt. In Fig. 4b ist im Vergleich zu Fig. 3b (ohne Übersteuerung) die Zunahme der Leistung der Harmonischen zu erkennen. Als Folge der Übersteuerung tauchen auch schwache Pegel an den Stellen der 1., 2., 6. und 7. Harmonischen auf.

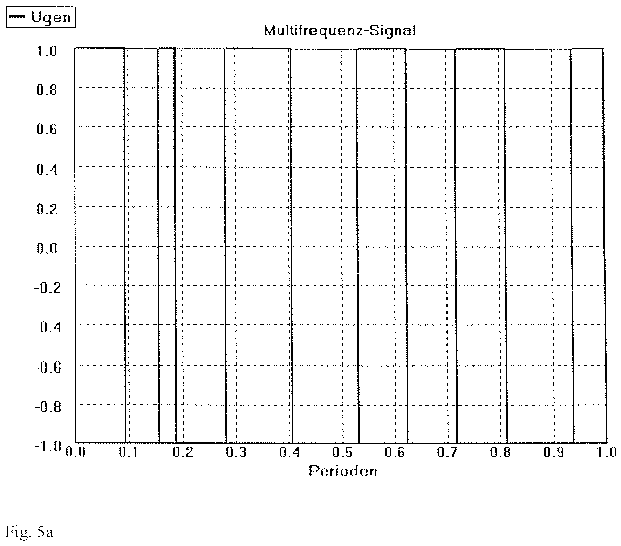

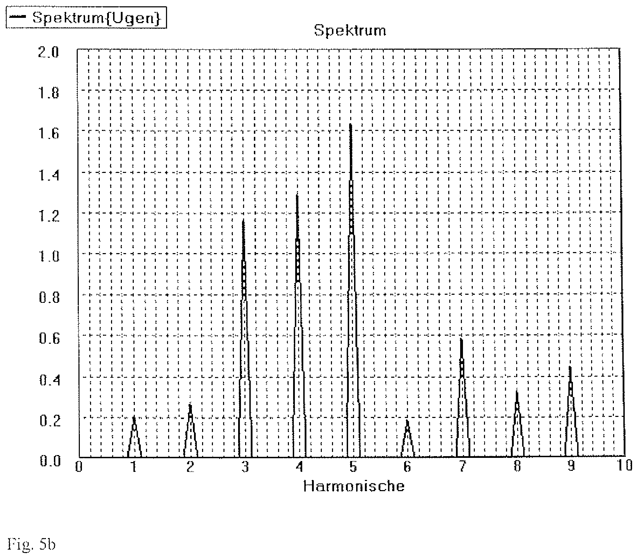

Die **Fig. 5a** und **5b** zeigen eine Rechteckimpuls-Folge mit dazugehörigem Spektrum, die aus einer Binärfolgen-Optimierung gezielt zur Maximierung der Leistung der 3., 4., und 5. Harmonischen erzeugt wurde. Zusätzlich wurde die Randbedingung gestellt, dass das diskrete Spektrum (für die erwünschten Harmonischen) im Rahmen einer Vorgabe ähnlich Gl. (6) monoton ansteigt, wie aus Fig. 5b klar ersichtlich ist. Hier wurde nicht ausgenutzt, dass eine Rechteckimpuls-Folge naturgemäß bereits eine mit 1/f abfallende spektrale Hüllkurve aufweist. Stattdessen steht die gezielte Erzeugung ausgewählter Harmonischer und die Einstellung der Leistungen dieser Harmonischen im Mittelpunkt, um ein Messsignal zu konstruieren, das eine hohe Störunempfindlichkeit aufweist.

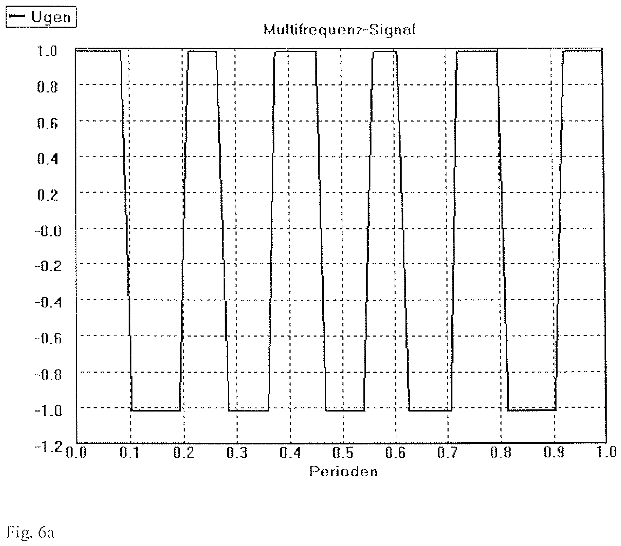

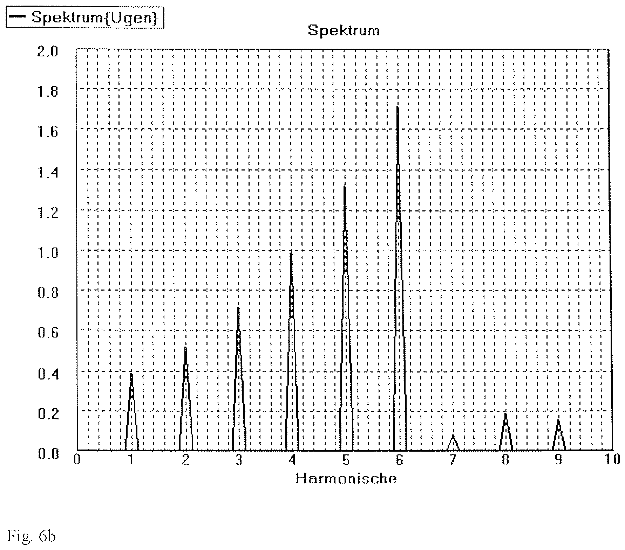

In den **Fig. 6a** und **6b** ist ein trapezförmiges Multifrequenz-Signal mit dazugehörigem Spektrum zu sehen, das aus der Nachbearbeitung einer Binärfolgen-optimierten Rechteckimpuls-Folge durch Einfügen linear interpolierender Stützstellen hervorgegangen ist. Die Trapezimpuls-Folge wurde mit Zielrichtung auf die Erzeugung von sechs ausgewählten, nutzbaren Harmonischen der Ordnungen 1 bis 6 bestimmt und weist, wie aus Fig. 6b erkennbar, nur noch schwach ausgeprägte höherer Harmonische auf.

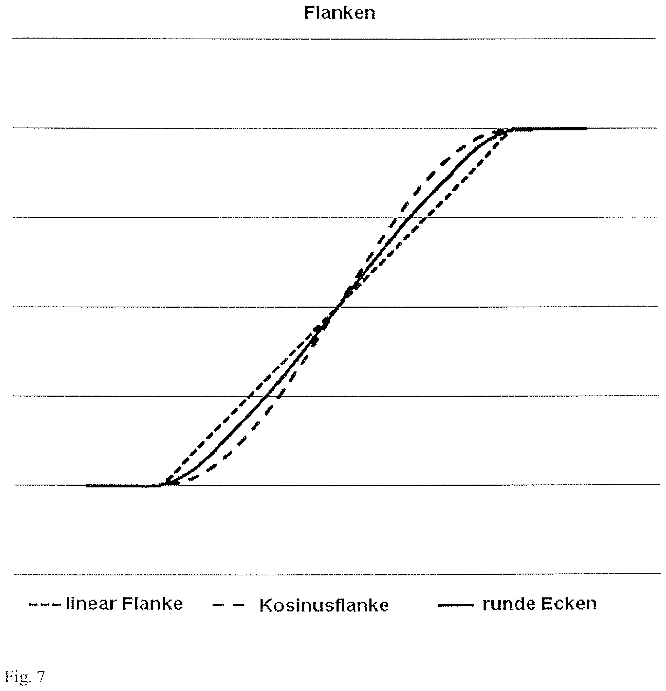

**Fig. 7** zeigt Beispiele verschiedener Flankenformen von modifizierten, nachbearbeiteten Rechteck-Impulsen, mit denen spektrale Vorgaben, beispielsweise hinsichtlich des Bandbreitenbedarfs, erfüllt werden können. Dargestellt sind eine lineare Flanke (kurz gestrichelte Linie), eine Kosinusflanke (lang gestrichelte Linie) und eine weitgehend linear verlaufende Flanke mit abgerundeten Übergängen zu konstanten Abschnitten (durchgezogene Linie).

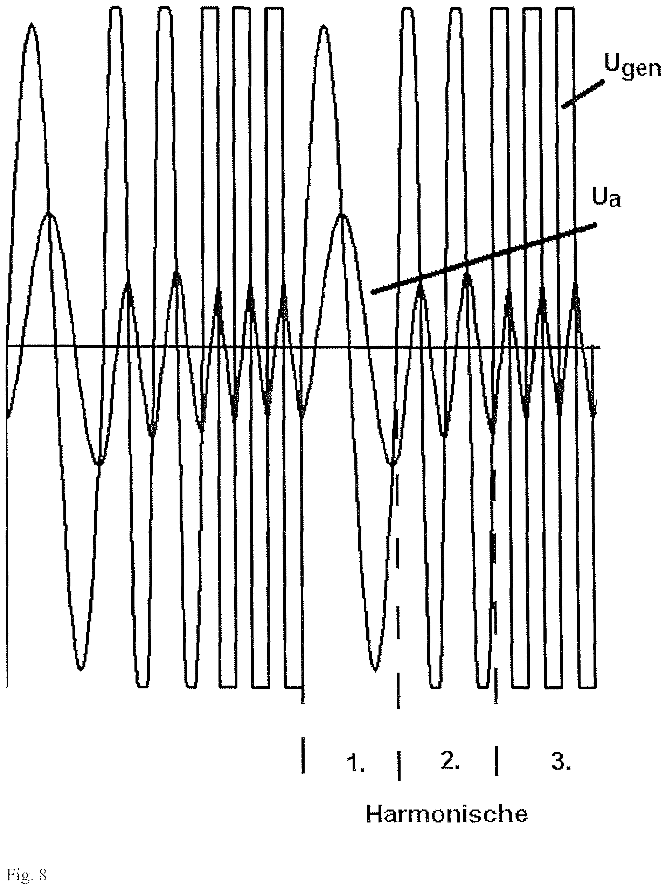

Die **Fig. 8** zeigt ein Beispiel des Messsignals $U_{gen}$ mit großer Amplitude, bei dem nacheinander im Zeitmultiplex-Verfahren die 1., 2. und 3. Harmonische der Grundfrequenz $f_{gen}$ erzeugt wurden. Die Wiederholperiode des resultierenden Messsignals entspricht der Summe der Längen der drei Signalabschnitte gleicher Länge (Signalgeneratorperioden $T_{gen}$), in denen jeweils die entsprechenden Harmonischen generiert werden. Bei gleichlangen Signalabschnitten bestehen nur eingeschränkte Möglichkeiten, die Amplituden (Aussteuerung) der einzelnen Harmonischen mit der Frequenz ansteigen zu lassen. Dennoch erkennt man, dass die 1. Harmonische leicht untersteuert, die 2. Harmonische etwas übersteuert (leichte Begrenzung) und die 3. Harmonische stark übersteuert (Rechteckform) ist.

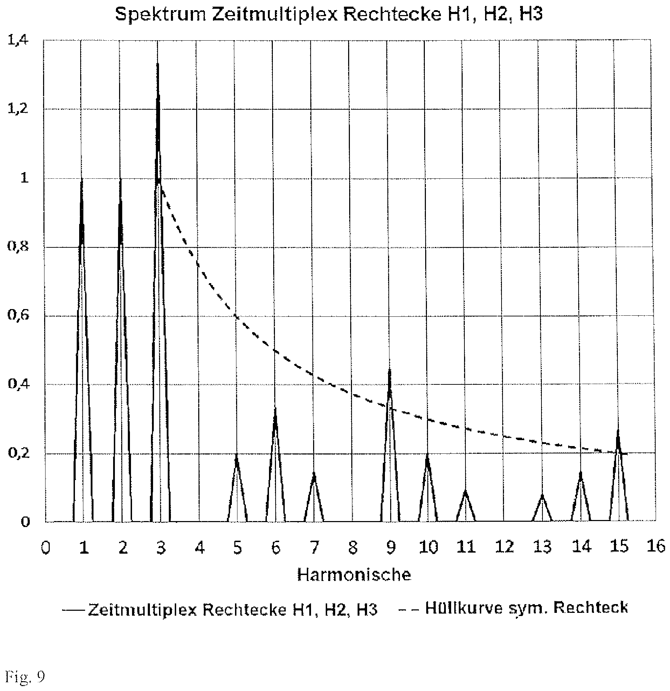

Die Sinussignale in den Signalabschnitten können auch durch Rechtecksignale ersetzt werden. So ist in **Fig. 9** ein Spektrum eines nach dem Zeitmultiplex-Verfahren zusammengesetzten Multifrequenz-Signals dargestellt, das sich aus der Integrationszeit über drei gleichlange Signalabschnitte (Signalgeneratorperioden $T_{gen}$) ergibt, wobei in den einzelnen Signalabschnitten nacheinander Rechtecksignale erzeugt wurden, deren jeweilige Grundfrequenz der jeweiligen Frequenz der Harmonischen 1., 2. und 3. Ordnung entspricht. Die Wiederholfrequenz beträgt $1/(3T_{gen})$. Man erkennt, dass bei dieser Konstruktion des Multifrequenz-Signals die auf der dritten Harmonischen beruhende Amplitudenverteilung über die Hüllkurve der einer mathematischen Zerlegung entsprechenden Fourier-Koeffizienten-Verteilung hinausragt. In dem hier dargestellten Fall profitiert also die gewollt erzeugte dritte Harmonische von der ersten Harmonischen, da die auf der ersten Harmonischen beruhender Rechteckschwingung selbst bereits einen Beitrag zur Amplitude der dritten Harmonischen leistet.

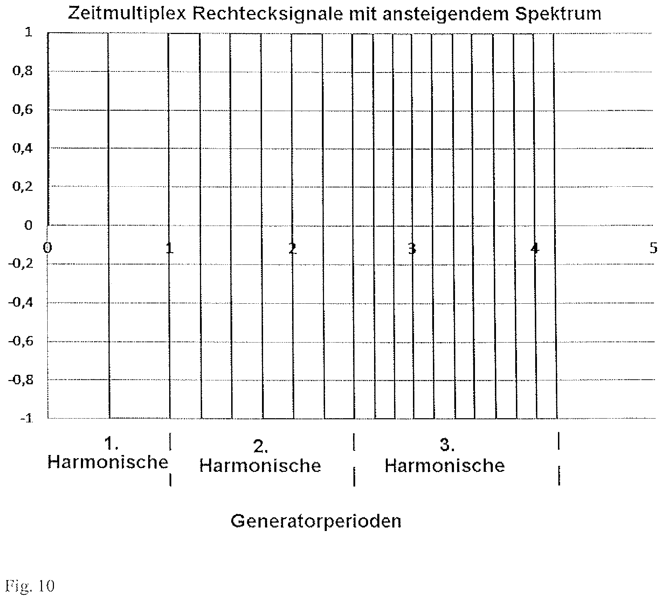

Mehr Gestaltungsmöglichkeiten eröffnet ein nach dem Zeitmultiplex-Verfahren zusammengesetztes Multifrequenz-Signal mit Signalabschnitten unterschiedlicher Länge, das in **Fig. 10** dargestellt ist. Hier erfolgt eine Einstellung der relativen Amplituden der Harmonischen zueinander durch eine Wichtung derart, dass die einzelnen Signalabschnitte unterschiedlich lang sind. In dem ersten Signalabschnitt der Länge $T_{gen}$ wird eine Rechteckschwingung der (Frequenz der) ersten Harmonischen erzeugt, gefolgt von einem Signalabschnitt der Länge $3/2\ T_{gen}$ mit der Erzeugung von drei Rechteckschwingungen der (Frequenz der) zweiten Harmonischen, gefolgt von einem Signalabschnitt der Länge $5/3\ T_{gen}$ mit der Erzeugung von fünf Rechteckschwingungen der (Frequenz der) dritten Harmonischen. Die Wiederholperiode beträgt somit $1+3/2+5/3=4.166$ Signalgeneratorperioden $T_{gen}$.

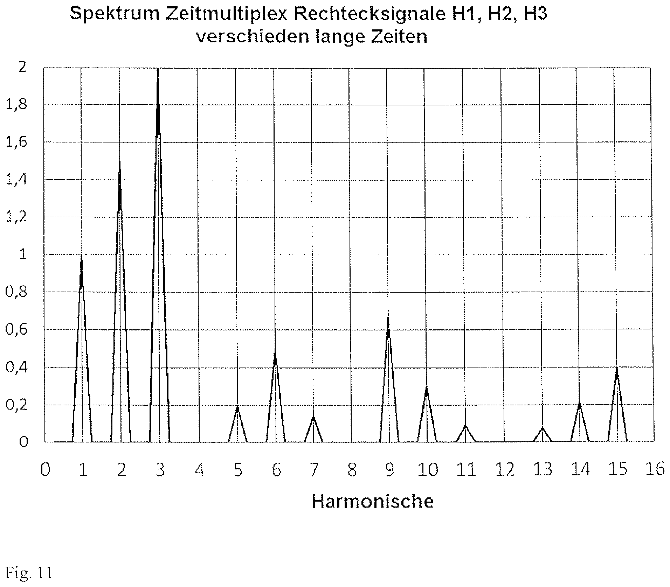

**Fig. 11** zeigt das dazugehörige Spektrum. Auf Grund der unterschiedlichen Längen der Signalabschnitte wären zwischen den ersten drei Harmonischen Amplitudenverhältnisse von 1:3/2:5/3 zu erwarten. Da aber die auf der ersten Harmonischen beruhende Rechteckschwingung bereits einen Beitrag zur dritten Harmonischen liefert, ist aus der Fig. 11 ein Verhältnis von 1:3/2:2 abzulesen, also ein erwünschter linear über die Frequenz zunehmender Verlauf mit der Steigung b=0.5 in Gl. (6).

**Patentansprüche**

1. Verfahren zur Überwachung und Messung eines Isolationswiderstandes (3) in ungeerdeten und geerdeten Stromversorgungssystemen, umfassend die Verfahrensschritte:

   Erzeugung eines periodischen Messsignals,
   Einkopplung des Messsignals zwischen aktiven Leitern (1) des zu überwachenden Stromversorgungssystems und Erde (2),
   Erfassung und Auswertung von Messsignal-Messwerten, wobei das erzeugte Messsignal als Multifrequenz-Signal durch eine Rechteckimpuls-Folge konstruiert wird,
   **dadurch gekennzeichnet, dass**
   ein die Folge bildender Rechteckimpuls in m gleichlange Teilabschnitte unterteilt wird,
   die m Teilabschnitte in geordneter Vorgehensweise jeweils binärwertig entweder unipolar auf 0/1 oder bipolar auf -1/+1 gesetzt werden, für jede der $2^m$ möglichen Rechteckimpuls-Folgen Fourier-Koeffizienten für ausgewählte Harmonische berechnet werden,
   Auswahl derjenigen Rechteckimpuls-Folge, die vorgegebene Anforderungen an ihre spektrale Zusammensetzung erfüllt.

2. Verfahren nach Anspruch 1,
   **dadurch gekennzeichnet,**
   **dass** die Leistungen ausgewählter Harmonischer in einem vorgegeben Aussteuerbereich maximal werden.

3. Verfahren nach Anspruch 1 oder 2,
   **dadurch gekennzeichnet,**
   **dass** niedrige Harmonische einer Grundfrequenz unterdrückt werden.

4. Verfahren nach einem der Ansprüche 1 bis 3,
   **dadurch gekennzeichnet,**
   **dass** die Amplituden der Harmonischen monoton mit der Frequenz ansteigen.

5. Verfahren nach einem der Ansprüche 1 bis 4,
   **dadurch gekennzeichnet,**
   **dass** die Amplituden der Harmonischen linear mit der Frequenz ansteigen.

6. Verfahren nach einem der Ansprüche 1 bis 5,
   **dadurch gekennzeichnet,**
   **dass** die Flanken der Rechteckimpuls-Folge durch Einfügen interpolierender Stützstellen nachbearbeitet werden, so dass sich eine von dem Rechteckimpuls abweichende Signalform ergibt.

7. Verfahren nach Anspruch 6,
   **dadurch gekennzeichnet,**
   **dass** durch linear interpolierende Stützstellen Trapezimpuls-Folgen erzeugt werden.

8. Verfahren nach Anspruch 6,
   **dadurch gekennzeichnet,**
   **dass** durch die interpolierenden Stützstellen Impulse mit Kosinusflanken oder mit weitgehend linear verlaufenden Flanken und abgerundeten Übergängen zu konstanten Abschnitten erzeugt werden.

9. Verfahren zur Überwachung und Messung eines Isolationswiderstandes (3) in ungeerdeten und geerdeten Stromversorgungssystemen, umfassend die Verfahrensschritte:

   Erzeugung eines periodischen Messsignals,
   Einkopplung des Messsignals zwischen aktiven Leitern (1) des zu überwachenden Stromversorgungssystems und Erde (2),
   Erfassung und Auswertung von Messsignal-Messwerten , wobei das erzeugte Messsignal als Multifrequenz-Signal gebildet wird,
**dadurch gekennzeichnet,**
**dass** das erzeugte Messsignal als Multifrequenz-Signal innerhalb einer Messsignalperiode, im Zeitmultiplex-Verfahren, durch zeitlich aufeinanderfolgende und stetig ineinander übergehende Signalabschnitte gebildet wird, die mit Funktionen unterschiedlicher, ausgewählter Ordnung eines orthogonalen Funktionensystems belegt werden.

10. Verfahren nach Anspruch 9,
**dadurch gekennzeichnet,**
**dass** die Funktionen sinusförmige Funktionen und deren Harmonische sind.

11. Verfahren nach Anspruch 10,
**dadurch gekennzeichnet,**
**dass** zur Steigerung des Effektivwertes höherer Harmonischer eine Übersteuerung und/oder eine Begrenzung der Signalabschnitte erfolgt.

12. Verfahren nach Anspruch 9,
**dadurch gekennzeichnet,**
**dass** die Funktionen Rechteckfunktionen, Walsh-Funktionen, Trapez-förmige Funktionen oder Funktionen mit Kosinusflanken sind.

13. Verfahren nach Anspruch 12,
**dadurch gekennzeichnet,**
**dass** die Trapez-förmigen Funktionen weitgehend linear verlaufende Flanken und abgerundete Übergänge zu konstanten Abschnitten aufweisen.

14. Verfahren nach einem der Ansprüche 9 bis 13,
**dadurch gekennzeichnet,**
**dass** die Signalabschnitte gleiche Länge aufweisen.

15. Verfahren nach einem der Ansprüche 9 bis 13,
**dadurch gekennzeichnet,**
**dass** eine Wichtung der Funktionen durch unterschiedlich lange Signalabschnitte erfolgt.

16. Signalgenerator zur Überwachung eines Isolationswiderstandes (3) in ungeerdeten und geerdeten Stromversorgungssystemen, mit einer Signalgeneratorschaltung (5) zur Erzeugung eines periodischen Messsignals und mit einer Ankopplungsschaltung (6) zur Einkopplung des Messsignals zwischen aktiven Leitern (1) des zu überwachenden Stromversorgungssystems und Erde (2),
**dadurch gekennzeichnet,**
**dass** die Signalgeneratorschaltung (5) Mittel zur Erzeugung und Speicherung des durch mindestens eines der erfindungsgemäßen Verfahren nach den Ansprüchen 1 bis 8 oder 9 bis 15 erzeugten Multifrequenz-Messsignale aufweist.

## Claims

1. A method for monitoring and measuring an insulation resistance (3) in unearthed and earthed power supply systems, comprising the method steps of:

   generating a periodic measuring signal,
   coupling in the measuring signal between active conductors (1) of the power supply system to be monitored and earth (2),
   detecting and evaluating measured values of the measuring signal,
   the generated measuring signal being constructed as a multi-frequency signal by means of a square pulse sequence,
   **characterised in that**
   a square pulse that forms the sequence is divided into m portions of equal length,
   each of the m portions is binarily set, in an ordered manner, either in a unipolar manner to 0/1 or in a bipolar manner to -1/+1,

Fourier coefficients for selected harmonics are calculated for each of the $2^m$ possible square pulse sequences,

the square pulse sequence is selected that fulfils the predefined requirements regarding its spectral composition.

2. The method according to claim 1,
**characterised in that**
the power of selected harmonics becomes maximal in a predefined dynamic range.

3. The method according to claim 1 or 2,
**characterised in that**
low harmonics of a fundamental frequency are suppressed.

4. The method according to any of the claims 1 to 3,
**characterised in that**
the amplitudes of the harmonics rise monotonically with the frequency.

5. The method according to any of the claims 1 to 4,
**characterised in that**
the amplitudes of the harmonics rise linearly with the frequency.

6. The method according to any of the claims 10 to 14,
**characterized in that**
the edges of the square pulse sequence are post-processed by inserting interpolating nodes, resulting in a signal form that deviates from the square pulse.

7. The method according to claim 6,
**characterised in that**
by means of linearly interpolating nodes, trapezoidal pulse sequences are generated.

8. The method according to claim 6,
**characterised in that**
by means of the interpolating nodes, pulses with cosine edges or with largely linearly running edges and rounded transitions to constant portions are generated.

9. A method for monitoring and measuring an insulation resistance (3) in unearthed and earthed power supply systems, comprising the method steps of:

generating a periodic measuring signal,
coupling in the measuring signal between active conductors (1) of the power supply system to be monitored and earth (2),
detecting and evaluating measured values of the measuring signal,
**characterised in that**
the generated measuring signal is formed as a multi-frequency signal within a measuring signal period, by means of the time-division multiplexing method, by temporally subsequent and continuously merging signal portions that are allocated with functions of different, selected order of an orthogonal function system.

10. The method according to claim 9,
**characterised in that**
the functions are sinusoidal functions and their harmonics.

11. The method according to claim 10,
**characterised in that**
for increasing the root mean square of higher harmonics, an overmodulation and/or a limitation of the signal portions takes place.

12. The method according to claim 9,
**characterised in that**
the functions are square functions, Walsh functions, trapezoidal functions or functions with cosine edges.

**13.** The method according to claim 12,
**characterised in that**
the trapezoidal functions have largely linearly running edges and rounded transitions to constant portions.

**14.** The method according to any of the claims 9 to 13,
**characterised in that**
the signal portions have the same length.

**15.** The method according to any of the claims 9 to 13,
**characterised in that**
a weighting of the functions takes place by means of differently long signal portions.

**16.** A signal generator for monitoring an insulation resistance (3) in unearthed and earthed power supply systems, comprising a signal generator circuit (5) for generating a periodic measuring signal and comprising a coupling circuit (6) for coupling in the measuring signal between active conductors (1) of the power supply system to be monitored and earth (2),
**characterised in that**
the signal generator circuit (5) comprises means for generating and storing the multi-frequency measuring signals generated by means of at least one of the methods of the invention according to the claims 1 to 8 or 9 to 15.

**Revendications**

**1.** Procédé de surveillance et mesure d'une résistance (3) d'isolement dans des systèmes d'alimentation non mis à la terre et mis à la terre, ledit procédé comprenant les étapes de procédé suivantes :

générer un signal de mesure périodique,
intégrer le signal de mesure entre des âmes (1) actives du système d'alimentation à surveiller et la terre (2),
détecter et évaluer des valeurs mesurées du signal de mesure, ledit signal de mesure généré étant construit comme un signal multifréquence au moyen d'une séquence d'impulsions rectangulaires,
**caractérisé en ce qu'**
une impulsion rectangulaire qui forme la séquence est divisée en m sections de même longueur,
que chacune des m sections est déterminée, d'une façon de procéder régulière, à valeur binaire ou de façon unipolaire à être 0/1 ou de façon bipolaire à être -1/+1,
que des coefficients de Fourier pour des harmoniques choisis sont calculés pour chacune des $2^m$ séquences d'impulsions rectangulaires possibles,
que la séquence d'impulsions rectangulaires est choisie qui répond à des exigences prédéfinies par rapport à sa composition spectrale.

**2.** Procédé selon la revendication 1,
**caractérisé en ce que**
les puissances d'harmoniques choisis deviennent maximales dans une gamme dynamique prédéfinie.

**3.** Procédé selon la revendication 1 ou 2,
**caractérisé en ce que**
des harmoniques bas d'une fréquence fondamentale sont supprimés.

**4.** Procédé selon l'une quelconque des revendications 1 à 3,
**caractérisé en ce que**
les amplitudes des harmoniques augmentent de façon monotone avec la fréquence.

**5.** Procédé selon l'une quelconque des revendications 1 à 4,
**caractérisé en ce que**
les amplitudes des harmoniques augmentent de façon linéaire avec la fréquence.

**6.** Procédé selon l'une quelconque des revendications 1 à 5,
**caractérisé en ce que**
les flancs de la séquence d'impulsions rectangulaires sont modifiés en insérant des points nodaux interpolants, entraînant une forme de signal qui s'écarte de l'impulsion rectangulaire.

7. Procédé selon la revendication 6,
   **caractérisé en ce que**
   des séquences d'impulsions trapézoïdales sont générées au moyen de points nodaux interpolants de façon linéaire.

8. Procédé selon la revendication 6,
   **caractérisé en ce qu'**
   au moyen des points nodaux interpolants, des impulsions avec des flancs cosinus ou avec des flancs qui sont largement linéaires et avec des transitions arrondies vers des sections constantes sont générées.

9. Procédé de surveillance et mesure d'une résistance (3) d'isolement dans des systèmes d'alimentation non mis à la terre et mis à la terre, ledit procédé comprenant les étapes de procédé suivantes :

   générer un signal de mesure périodique,
   intégrer le signal de mesure entre des âmes (1) actives du système d'alimentation à surveiller et la terre (2),
   détecter et évaluer des valeurs mesurées du signal de mesure, ledit signal de mesure généré étant formé comme un signal multifréquence,
   **caractérisé en ce que**
   ledit signal de mesure généré est formé comme un signal multifréquence en l'espace d'une période de signal de mesure par multiplexage temporel au moyen de parties de signal qui se suivent dans le temps et qui sont en continuité l'une avec l'autre de façon continue et auxquelles des fonctions d'ordre choisi différent d'un système de fonctions orthogonales sont attribuées.

10. Procédé selon la revendication 9,
    **caractérisé en ce que**
    les fonctions sont des fonctions sinusoïdales et leurs harmoniques.

11. Procédé selon la revendication 10,
    **caractérisé en ce que**
    pour augmenter la valeur moyenne quadratique d'harmoniques de rang plus élevé, une surmodulation et/ou une limitation des parties de signal a lieu.

12. Procédé selon la revendication 9,
    **caractérisé en ce que**
    les fonctions sont des fonctions rectangulaires, des fonctions Walsh, des fonctions trapézoïdales ou des fonctions avec des flancs cosinus.

13. Procédé selon la revendication 12,
    **caractérisé en ce que**
    les fonctions trapézoïdales ont des flancs qui sont largement linéaires et des transitions arrondies vers des sections constantes.

14. Procédé selon l'une quelconque des revendications 9 à 13,
    **caractérisé en ce que**
    les parties de signal sont de même longueur.

15. Procédé selon l'une quelconque des revendications 9 à 13,
    **caractérisé en ce que**
    les fonctions sont pondérées au moyen de parties de signal de longueur différente.

16. Générateur de signaux pour surveiller une résistance (3) d'isolement dans des systèmes d'alimentation non mis à la terre et mis à la terre, comportant un circuit (5) de générateur de signaux pour générer un signal de mesure périodique et comportant un circuit (6) de couplage pour intégrer le signal de mesure entre des âmes (1) actives du système d'alimentation à surveiller et la terre (2),
    **caractérisé en ce que**
    le circuit (5) de générateur de signaux a des moyens pour générer et stocker les signaux de mesure multifréquence générés au moyen d'au moins un des procédés selon l'invention selon les revendications 1 à 8 ou 9 à 15.

Fig. 1

Fig. 2

Fig. 3a

Fig. 3b

Fig. 4a

Fig. 4b

Fig. 5a

Fig. 5b

Fig. 6a

21

Fig. 6b

Flanken

- - - linear Flanke    - - Kosinusflanke    —— runde Ecken

Fig. 7

Fig. 8

**Spektrum Zeitmultiplex Rechtecke H1, H2, H3**

—Zeitmultiplex Rechtecke H1, H2, H3    – – Hüllkurve sym. Rechteck

Fig. 9

## Zeitmultiplex Rechtecksignale mit ansteigendem Spektrum

1. Harmonische | 2. Harmonische | 3. Harmonische |

Generatorperioden

Fig. 10

### Spektrum Zeitmultiplex Rechtecksignale H1, H2, H3
### verschieden lange Zeiten

Harmonische

Fig. 11

**EP 2 717 063 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3882833 T2
- EP 0593007 B1
- US 20110085272 A1